# EUROPEAN PATENT APPLICATION

(11) **EP 4 791 174 A2**
(43) Date of publication of application: **12.08.2026**
(21) Application number: 26150120.9
(22) Date of filing: 05.01.2026
(51) Int. Cl.: H10P 54/00, B23K 26/0622, B23K 26/08, B23K 26/359, B23K 26/364, B23K 26/38, B23K 26/402, B23K 26/53, B23K 26/067

(54) **DICING METHODS**

(30) Priority: 16.01.2025 US 202519024490
(71) Applicant: ASMPT Singapore Pte. Ltd., Singapore 768924 (SG)
(72) Inventor: ZIJLSTRA, Niels, 6641 TL Beuningen (NL); NAUMOV, Alexander, 6641 TL Beuningen (NL)
(74) Representative: Emerson, Peter James

(57) **Abstract**

A method for breaking a substantially planar workpiece having first and second major surfaces, with a metallization layer on the first major surface, comprises the steps of:
i) forming a groove in the workpiece extending parallel to the plane, the groove being open at an upper surface of the workpiece, and then subsequently
ii) applying a workpiece breaking force to the first major surface of the workpiece to crack the workpiece along a break line coincident with the groove, then
iii) applying a metallization breaking force to the second major surface of the workpiece to break the metallization layer along the break line.

## Description

This invention relates to a method for breaking a substantially planar workpiece having first and second major surfaces, with a metallization layer on the first major surface, and a method for scribing a substantially planar workpiece.

### Background and Prior Art

Singulation and scribing are well-known processes in the semiconductor industry, in which a cutting machine is used to work a workpiece or substrate such as a semiconductor wafer, which could for example comprise silicon but is not so limited, or metal and / or ceramic wafer. Throughout this specification, the term "wafer" is used to encompass all these products. In a singulation process (also referred to as dicing, severing, cleaving for example), a wafer is completely cut through such as to singulate the wafer into individual dies or chips. In a scribing process (also referred to as grooving, scoring, gouging or furrowing for example), a channel or groove is cut into a wafer. Other processes may be applied subsequently, for example full singulation by using a physical saw along the cut channels.

Silicon Carbide (SiC) is an emerging substrate material to replace silicon for advanced power electronics. For many applications, SiC offers superior performance due to its high-temperature and high-voltage performance compared to standard silicon devices.

Since SiC is almost as hard as diamond, separating wafers into individual chips is a challenging process. Currently, mechanical blade dicing is most used for dicing SiC wafers. However, such blade dicing suffers from a very low feed rate, low edge quality, and fast wear of the dicing blade. As the use of 150 mm or even 200 mm SiC wafers becomes more standard, blade dicing will most probably reach its limit because of these shortcomings.

For thin SiC wafers (roughly <150 micrometer thick), laser ablation is a good alternative to replace the mechanical blade, since it can obtain sufficient quality and significantly improves the throughput. In a laser ablation process, removal of the semiconductor material occurs due to a rapid temperature increase of a relatively small area in which the laser beam is focused, which causes local material to melt, explosively boil, evaporate and ablate. Laser singulation has challenging requirements, including the delicate balance between the process throughput and the workpiece (die) quality. The quality and throughput of the process are determined by laser parameters such as fluence, pulse width, repetition rate and wavelength.

For thicker SiC wafers however (about 150 - 350 micrometer thickness), there is not yet a good alternative to replace the mechanical blade, especially for applications where the mechanical die strength of the individual chips is important. Laser ablation for such wafers also suffers from a very low throughput and increasingly poor quality. Additionally, the mechanical die strength that can be obtained with laser ablation is limited, and has difficulty satisfying the current requirements.

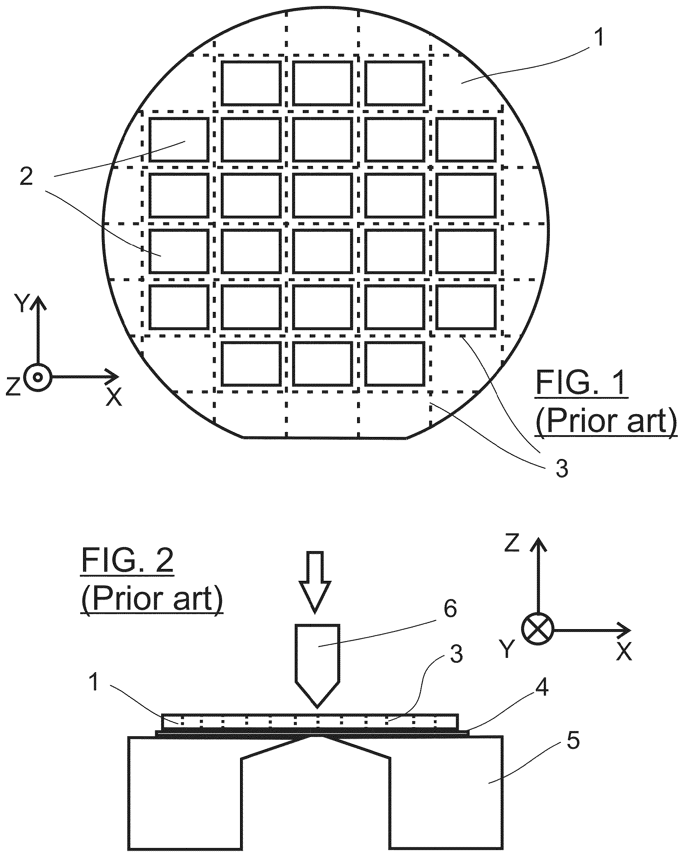

Laser scribe-and-break approaches are well known. In such processes, a laser is used to create lines of weakness in a wafer before a mechanical breaking action is applied, breaking the wafer along those lines of weakness. This process is schematically shown in FIGs. 1 and 2.

FIG. 1 schematically shows, from above, a substantially planar wafer 1 which has been scribed using a laser-scribing process. As shown, the wafer 1 is provided with a plurality of electronics devices 2, which are arranged in a regular array so that straight channels extend between the devices 2. Scribelines 3 are formed along these channels using an incident laser which is directed to the upper surface of the wafer, so that each device 2 is separated from its neighboring devices 2 by a scribeline 3.

FIG. 2 schematically shows, from the side, the wafer 1 about to be mechanically broken in a manner which is known in the art per se. For clarity, devices 2 are omitted. In this view, it can be seen that the wafer 1 is adhered, at its lower surface, to a flexible sheet 4, known as dicing tape. The wafer 1 and flexible sheet 4 are held within a frame (not shown for clarity). The assembly of wafer 1 and sheet 4 is supported on a rigid support assembly or anvil 5. This support assembly 5 may be used to support the wafer 1 during scribing, or the wafer 1 may be positioned on a chuck (not shown) while scribing, then moved to such a support assembly 5 following completion of scribing.
In FIG. 2, the wafer 1 is broken by mechanically pressing down on the upper surface of the wafer 1, for example using a blade or chisel 6 as shown, causing the wafer 1 to crack along the scribelines 3, which are weaker than the surrounding wafer material.

However these processes also have shortcomings for SiC, in particular causing a relatively poor mechanical die strength.

In addition, the current laser scribe-and-break methods are not suited for breaking substrates which have a metallization layer provided on one of their major surfaces. For such substrates it is generally required to cut through the metallization layer, either mechanically or with a laser.

The present invention seeks to provide improved cutting and breaking methods, which are suitable for scribing hard materials, such as SiC, even of relatively high thicknesses, and specifically for breaking materials provided with metallization layers, in particular metallization layers having thicknesses between about 0.5 and 5 µm.

In accordance with the present invention this aim is achieved by using laser-scribing apparatus to scribe a specially-shaped scribeline or groove into a workpiece, which scribeline forms a line of weakness in the workpiece to enable subsequent breaking of the workpiece. In one aspect, the scribeline or groove is produced using a combination of different scribing regimes, in particular a first regime which creates a relatively deep and narrow groove, and a second regime which removes heat-affected material from areas of the workpiece proximate an upper portion of the groove. In another aspect, a workpiece with a metallization layer may be broken by applying a scribing process followed by mechanical breaking steps sequentially applied to each major surface of the workpiece.

### Summary of the Invention

In accordance with a first aspect of the present invention there is provided a method for breaking a substantially planar workpiece having first and second major surfaces, with a metallization layer on the first major surface, comprising the steps of:
i) forming a groove in the workpiece extending parallel to the plane, the groove being open at an upper surface of the workpiece, and then subsequently
ii) applying a workpiece breaking force to the first major surface of the workpiece to crack the workpiece along a break line coincident with the groove, then
iii) applying a metallization breaking force to the second major surface of the workpiece to break the metallization layer along the break line.

In accordance with a second aspect of the present invention there is provided a method for scribing a substantially planar workpiece, comprising the steps of:
i) irradiating the workpiece with a first irradiation pattern of incident laser light while moving the workpiece relative to the incident laser light, to form a groove in the workpiece extending parallel to the plane, the groove being open at an upper surface of the workpiece and having a first sectional shape with a first depth d1, and then subsequently
ii) irradiating the workpiece with a second irradiation pattern of incident laser light, while moving the workpiece relative to the incident laser light, to modify an upper portion of the groove, the upper portion having a depth d2, where d2<d1, to produce a modified groove having a second sectional shape different to the first sectional shape.

Other specific aspects and features of the present invention are set out in the accompanying claims.

### Brief Description of the Drawings

The invention will now be described with reference to the accompanying drawings (not to scale), in which:
FIG. 1 schematically shows, from above, a wafer which has been scribed using a laser;
FIG. 2 schematically shows the wafer of FIG. 1 from the side, in readiness for a breaking step;
FIGs. 3 schematically shows, from the side, an exemplary laser-scribing apparatus for performing a laser-scribing method in accordance with the present invention;
FIG. 4 schematically shows, from above, a portion of a wafer as it is being initially scribed in accordance with an embodiment of the present invention;
FIG. 5 schematically shows, from above, a portion of a wafer as it is being initially scribed in accordance with an alternative embodiment of the present invention;
FIG. 6 schematically shows, in a sectional side view, a groove produced following initial scribing;
FIG. 7 schematically shows, from above, a portion of a wafer as it is being subsequently scribed in accordance with an embodiment of the present invention;
FIG. 8 schematically shows, from the side, a scribeline produced following subsequent scribing;
FIG. 9 schematically shows, from above, a portion of a wafer being scribed in accordance with an embodiment of the present invention;
FIG. 10 schematically shows, from above, a portion of a wafer being scribed in accordance with an alternative embodiment of the present invention;
FIG. 11 schematically shows, in a sectional side view, a wafer with a composite metallization layer;
FIG. 12 diagrammatically shows a scribing sub-process of a breaking method in accordance with the present invention;
FIG. 13 diagrammatically shows a breaking sub-process of the breaking method;
FIG. 14 schematically shows, from the side, apparatus arranged to break a wafer during the breaking sub-process; and
FIG. 15 schematically shows, from the side, apparatus arranged to break a metallization layer during the breaking sub-process.

### Detailed Description of the Preferred Embodiments of the Invention

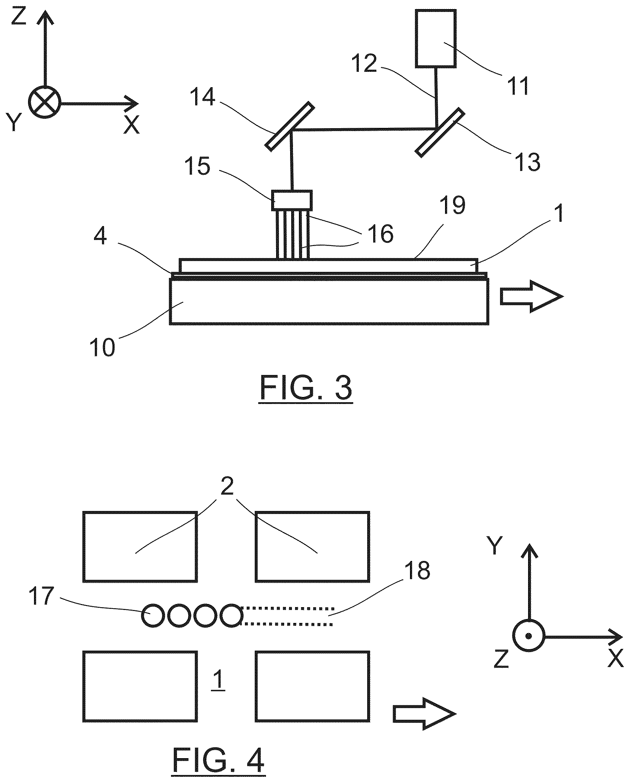

A first embodiment of the present invention, relating to a scribing process suitable for SiC workpieces with or without a metallization layer will now be described with reference to FIGs. 3 to 10. Once scribed in accordance with the present invention, the workpiece will appear, from above, similar to that shown in FIG. 1 and may be mechanically broken using a process similar to that shown in FIG. 2. As such, reference numerals will be retained from those figures wherever possible.

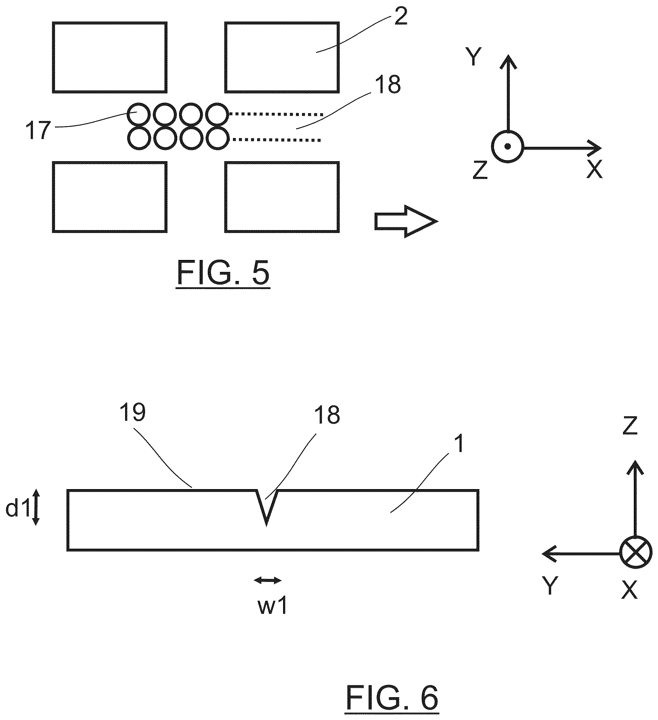

In accordance with this embodiment of the present invention, the scribelines 3, which act as lines of weakness so that they preferentially break when the wafer 1 is subjected to a mechanical breaking process as described above, are formed by a two-part scribing process. In a first part of the process, a relatively narrow and deep groove (18, see FIG. 6) is formed, while in a second part of the process, this first groove 18 is modified to remove heat-affect material from about the upper region of the groove 18.

FIG. 3 schematically shows, from the side, an exemplary laser-scribing apparatus for use in performing the laser-scribing method of the present invention.

A laser source 11 is arranged to output a laser beam 12, which is directed along an optical path to the wafer 1 via first and second mirrors 13, 14. A beam shaper 15, such as diffractive optical element (DOE), spatial light modulator or the like, is positioned in the optical path to create an irradiation pattern of incident laser light comprising sub-beams 16 at the wafer 1, as will be described in more detail below. The laser source 11 is selected so that the laser beam 12 produced thereby is capable of ablating the material of the wafer 1. For example, a suitable laser source 11 may produce a laser beam of wavelength in the range of about 300 to 380 nm, optionally in the range of about 330 to about 370 nm, with a pulse duration in the range from about 10 ns to about 250 ns at around 10-100 kHz, or about 0.1 ps to about 10 ps at around 100 to 2000 kHz, and output power in the range from about 0.1W to about 10W. In this embodiment, the wafer 1 and flexible sheet 4 are supported on a chuck 10 which is drivable within the horizontal (X-Y) plane, as shown by the large arrow. The laser assembly, i.e. the laser source 11, mirrors 13, 14 and beam shaper 15, is held stationary, while the chuck 10 moves the wafer 1 relative to the incident laser light. This relative movement, in a translation direction, while the wafer 1 is being irradiated by the incident laser light acts to ablate wafer material along a line in the upper surface 19 of the wafer 1 parallel to the translation direction.

In other embodiments (not shown), the wafer 1 may be held stationary while the laser beam is translated, or both the wafer 1 and laser beam are translated.

Scribing techniques using illumination patterns obtained from beam shapers such as DOEs are known, for example from US9120178B2.

The first part of the process, i.e. the production of a relatively deep and narrow groove 18 in the upper surface 19 of the wafer 1 by an initial scribing, will now be described with reference to FIGs. 4 to 6.

In more detail, this first part of the process involves irradiating the wafer 1 with a first irradiation pattern of incident laser light while moving the wafer 1 relative to the incident laser light in the translation direction, to form a groove 18 (see FIG. 6) in the wafer 1 extending parallel to its plane, the groove 18 being open at an upper surface 19 of the wafer 1 and having a first sectional shape with a first depth d1.

FIG. 4 schematically shows, from above, a portion of a wafer 1 as it is being initially scribed in accordance with an embodiment of the present invention. As shown, the beam shaper 15 (see FIG. 3) is configured to create a first illumination pattern in which a linear array of spatially-separated laser sub-beams split from the laser beam 12 illuminate a respective plurality of spots 17 onto the upper surface of the wafer 1. In this respect, the term "linear array" is used to describe a pattern in which the maximum number of spots 17 illuminating the wafer 1 does not change along the length of the direction of relative motion of the wafer 1 and the laser assembly, as shown by the large arrow in FIG. 4, and also that the position of these spots in the direction orthogonal to this direction also does not change. In the example shown in FIG. 4, the linear array has a single sub-beam (i.e. producing a single spot 17) in the direction orthogonal to the translation direction, and four sub-beams (i.e. producing four corresponding spots 17) extending along a line parallel to the translation direction. The illumination pattern ablates a relatively narrow region of wafer material, creating a relatively narrow and deep groove 18 in the upper surface 19 of the wafer 1.

FIG. 5 shows a first illumination pattern in accordance with an alternative embodiment of the present invention, in which the linear array of laser sub-beams has two sub-beams (i.e. producing two spots 17) in the direction orthogonal to the translation direction, and four sub-beams (i.e. producing four spots 17) extending along a line parallel to the translation direction.

Other forms of first illumination pattern are also possible.

FIG. 6 schematically shows, in a sectional side view, a groove 18 produced during this initial scribing process. The use of a linear array of sub-beams creates a groove 18 having a substantially V-shaped profile, being open at the upper surface 19. As shown, the groove 18 has a sectional shape with a maximum depth d1. The maximum width w1 of the groove 18 is at the upper surface 19. Where the wafer 1 has a thickness in the range 100 to 350 µm, the groove 18 may advantageously have a depth in the range 5 to 60 µm, optionally the wafer 1 has a thickness in the range 100 to 200 µm and the groove 18 has a depth in the range 5 to 15 µm, optionally the wafer 1 has a thickness in the range 200 to 350 µm and the groove 18 has a depth in the range 40 to 60 µm.

In accordance with this aspect of the present invention, once groove 18 has been formed, a subsequent process is performed comprising irradiating the wafer 1 with a second irradiation pattern of incident laser light, while moving the wafer 1 relative to the incident laser light in a direction parallel to the translation direction, to modify an upper portion of the groove 18, the upper portion having a depth d2, where d2<d1, to produce a modified groove 20 having a second sectional shape different to the first sectional shape. The modification acts to remove parts of the wafer 1 in the vicinity of the upper part of the groove 18, which are susceptible to heat damage during the initial scribing process. This preferably includes the so-called "heat-affected zone" (HAZ) of the wafer 1.

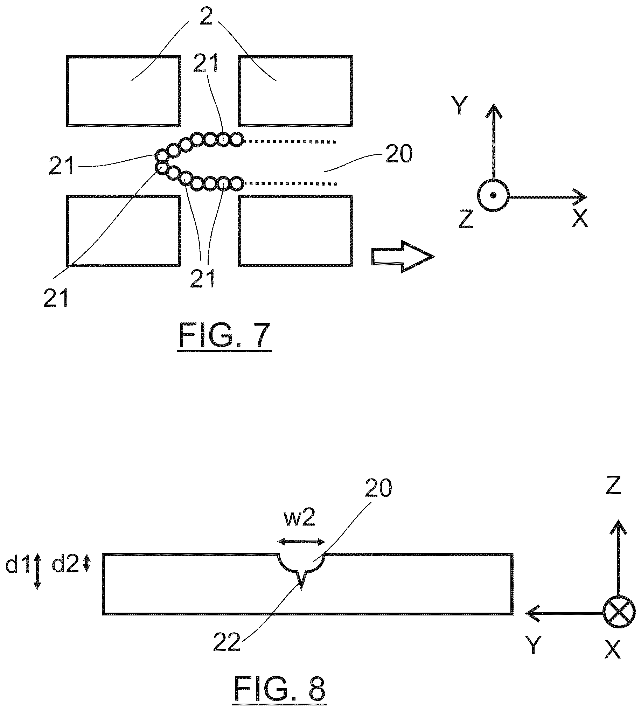

FIG. 7 schematically shows, from above, a portion of the wafer 1 as it is being subsequently scribed in accordance with an embodiment of the invention, while FIG. 8 schematically shows, from the side, a modified groove 20 produced by this subsequent scribing.

In this embodiment, the second irradiation pattern comprises a plurality of sub-beams (i.e. producing corresponding spots 21) arranged in a V-shaped pattern such that the width of the pattern, orthogonal to the translation direction, increases in the translation direction (with the translation direction being shown by the large arrow). The V-shape has its base at the leading side of the second irradiation pattern. It can also be seen that the second irradiation pattern comprises a plurality of pairs of sub-beams spaced parallel to the translation direction (i.e. spaced parallel to the X direction shown), each pair comprising first and second sub-beams spaced in the horizontal direction orthogonal to the translation direction (i.e. spaced parallel to the Y direction shown), with the spacing between the first and second sub-beams of each pair (parallel to the Y direction) increasing in the translation direction.

This V-shape profile acts on a relatively wide and shallow region of the wafer 1, creating a composite modified groove profile schematically shown in FIG. 8. Here it can be seen that the original groove 18 created by the first process is modified - in more detail an upper portion of the groove 18 is modified, the upper portion having a depth d2, where d2<d1, to produce a modified groove 21 having a second sectional shape different to sectional shape of groove 18. The maximum width of the modified groove 21, located at the upper surface of the wafer 1, is w2, where w2 > w1 (see FIG. 7). As noted above, the modification affects the upper portion of groove 18, leaving the lower section of the groove 18 unaffected - as shown in FIG. 8 a relatively deep and narrow trough 22 remains extending down into the body of the wafer 1. This trough 22 is beneficial in a subsequent mechanical breaking process, since it creates a well-defined line of weakness.

In a preferred embodiment, the same laser-scribing apparatus (such as that shown in FIG. 3) may be used to perform both the first part and the second part of the process outlined above. In this case, there are two main possibilities:
i) a first beam shaper is used which produces a first illumination pattern to create a groove 18 in the wafer 1 in the first part of the process, then the beam shaper 15 is replaced by a different beam shaper positioned in the optical path which creates a second illumination pattern, and the wafer 1 is again translated relative to the laser assembly such that the second illumination pattern modifies the groove 18; or
ii) a single beam shaper 15 is provided which is operative to divide the laser beam into first and second laterally spaced irradiation patterns (i.e. creating a relatively complex composite irradiation pattern), such that a groove 18 is formed in the wafer 1 by the first irradiation pattern, and the groove 18 is, immediately afterwards, modified by the second illumination pattern.

However, equally two separate laser-scribing apparatuses may be used, each for performing a single one of the first and second parts of the process, each laser-scribing apparatus being provided with a dedicated beam shaper for performing the respective part of the process. A wafer 1 which has had a groove 18 formed in it by use of the first laser-scribing apparatus would be physically placed into the second laser-scribing apparatus so that modification of the groove 18 may be performed.

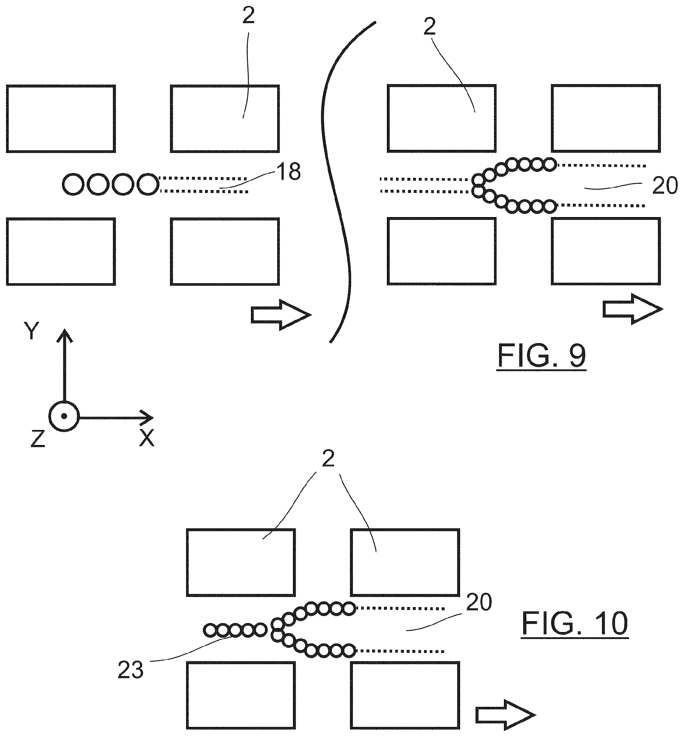

FIG. 9 schematically shows, from above, a portion of a wafer 1 being scribed in accordance with an embodiment of the present invention using separate scribing operations for each of the first and second parts of the process. As described above, this may be achieved by using the same laser-scribing apparatus but with different beam shapers, or by using two separate laser-scribing apparatuses.

FIG. 10 schematically shows, from above, a portion of a wafer being scribed in accordance with an alternative embodiment of the present invention, in which the modified groove 20 is formed in a single scribing operation, within a single laser-scribing apparatus. In this case, a single, more complex beam-shaper is used which can produce a composite irradiation pattern 23 of sub-beams, which includes a linear array of sub-beams, followed by a V-shaped sub-beam profile.

Following production of all required modified grooves 20, the wafer 1 may be mechanically broken using a method as described with respect to FIG. 2 or similar alternatives.

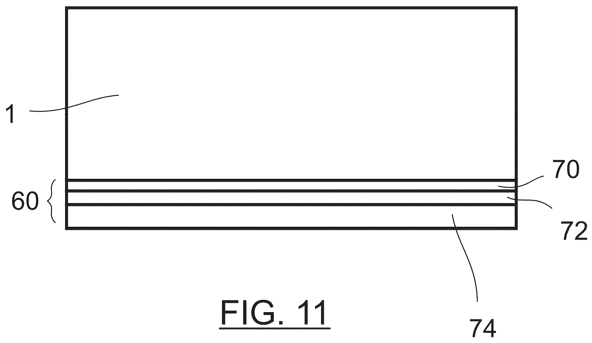

A second embodiment of the present invention, relating to a breaking process suitable for SiC workpieces or wafers with a metallization layer will now be described with reference to FIGs. 11 to 15. It is important to note that this breaking process, while making use of laser-scribing, does not necessarily require the two-stage process described above with reference to the first embodiment, although such a scribing process is of even more benefit. Like reference numerals will be retained where possible from previous figures.

Wafers 1 may be provided with various forms of metallization layers 60, including composite metallization layers including a plurality of layers of different metallic materials. FIG. 11 schematically shows, in a sectional side view, a wafer 1 with an exemplary composite metallization layer 60. In this exemplary case, the composite metallization layer 60 includes a layer 70 adjacent the substrate of Ti, having a thickness in the range of about 0.01 to 0.1 µm, a layer 72, adjacent to layer 70, of Ni or NiV having a thickness in the range of about 0.1 to 0.5 µm, and a layer 74, adjacent layer 72, of Au or Ag, having a thickness in the range of about 0.5 to 5 µm. In general, the present invention is particularly applicable to the breaking of metallization layers 60 having thicknesses between about 0.5 and 5 µm, though the invention is not limited thereto.

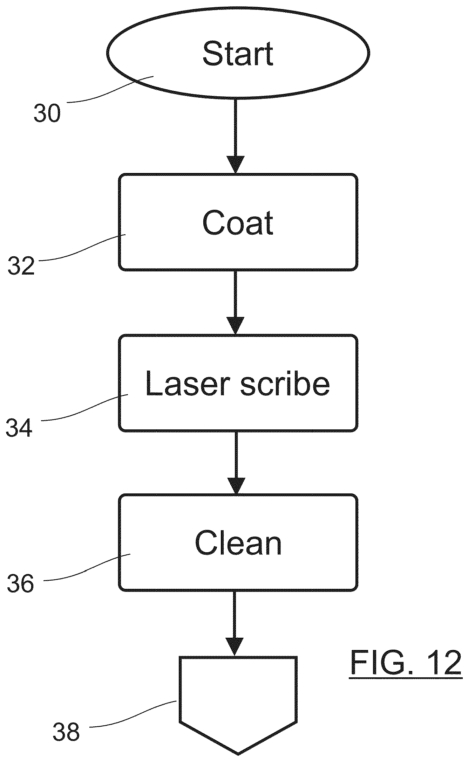

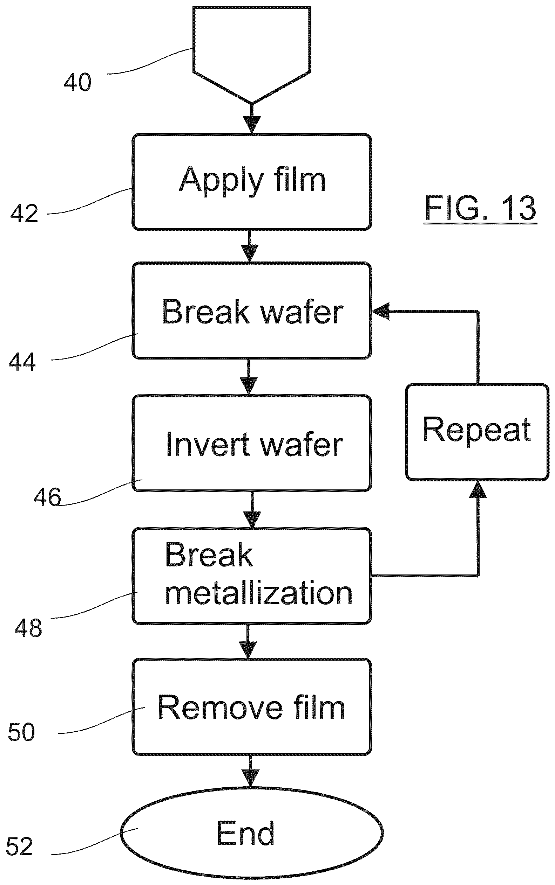

FIGs. 12 and 13 describe the breaking process as a flowchart, with FIG. 12 showing a first part of the process associated with a laser-scribing sub-process, and FIG. 13 showing a second part of the process associated with a breaking sub-process.

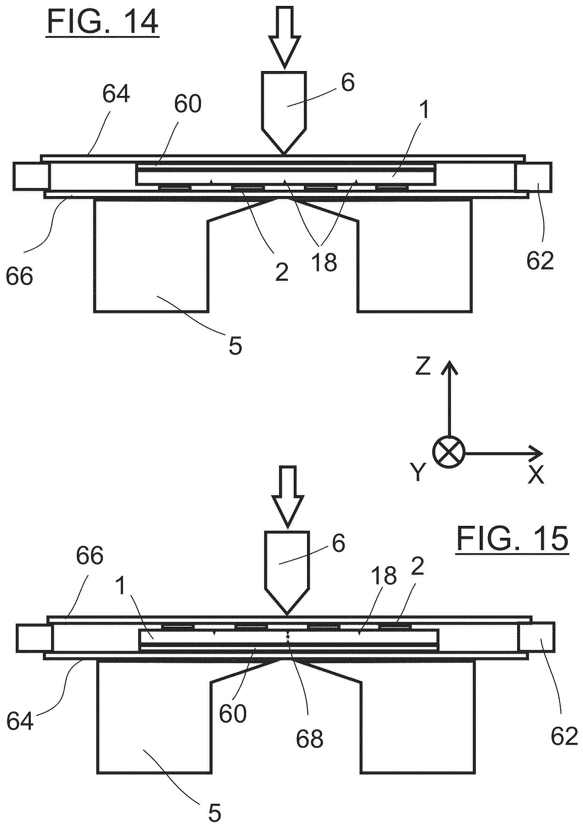

The process starts at 30, with an unscribed wafer 1, the first or lower major surface, which comprises a metallization layer thereon, being held within a frame 62 (see FIG. 14) by a layer of dicing tape 64 (see FIG. 14), as is well-known in the art per se. The upper, or second major surface is provided with a plurality of devices 2. The wafer 1 may for example comprise silicon carbide (SiC).

In step 32, the unscribed wafer 1 is coated, on its second major surface, with a coating such as a thin (in the order of microns) layer of a polymer material, as is generally known in the art, which acts to prevent material ablated during subsequent step 34 from contacting the wafer 1.

In step 34, the wafer 1 is scribed using a laser, creating at least one groove 18 between the device 2. This step may be performed using apparatus similar or identical to that shown in FIG. 3 for example. In more detail, this step may comprise irradiating the second major surface of the wafer 1 with incident laser light while moving the wafer 1 relative to the incident laser light in a translation direction, to form the groove 18. It is particularly effective, though not essential, to create a groove 18 which has a profile as described in the previous embodiment with reference to FIGs. 4 to 10, i.e. in which initially a groove of a first sectional shape is formed, before the upper portion of the groove is modified to produce a modified groove 18 having a second sectional shape different to the first sectional shape. Whatever the sectional shape of the groove 18, advantageously, if the wafer 1 has a thickness in the range 100 to 350 µm then the groove 18 may have a depth in the range 5 to 60 µm, optionally if the wafer 1 has a thickness in the range 100 to 200 µm then the groove 18 may have a depth in the range 5 to 15 µm, optionally if the wafer has a thickness in the range 200 to 350 µm, then the groove 18 may have a depth in the range 40 to 60 µm. The incident laser light may advantageously have a wavelength in the range from 300 to 380 nm, optionally in the range 330 to 350 nm. The incident laser light may advantageously comprise a pulsed beam with a frequency in the range 10 to 100 kHz and a pulse duration in the range 10 to 250 ns. The incident laser light may advantageously comprise a pulsed beam with a frequency in the range 100 to 2000 kHz and a pulse duration in the range 0.1 to 10 ps. The incident laser light may advantageously have a power in the range 0.1 to 10 W.

In step 36, the scribed wafer 1 is cleaned to remove the coating applied in step 32 and any debris arising from the scribing process. This may be achieved by, for example, rotating the wafer 1 and spraying water onto it at high pressure, as is known in the art per se.

The laser-scribing sub-process is now complete, and, at step 38, the process moves to a breaking sub-process, which starts at 40 (see FIG. 13).

In step 42, a protective film 66 (see FIG. 14) is applied to the second major surface of the wafer 1. This may comprise, for example, a non-adhesive, (semi) transparent plastic film (such as, for example only, PVC, PET, PO or Mylar (RTM)) that is applied in a reasonably thin layer, for example less than about 100 um. The protective film 66 is applied for two main reasons:
i) to protect the active areas on the wafer, which would otherwise be in contact with the support 5; and
ii) to prevent the dicing tape 64, which is sticky, from adhering either to the support 5 or the blade or chisel 6.

In step 44, the wafer 1 is broken. In more detail, a wafer breaking force is applied to the first major surface of the wafer 1 to crack the wafer 1 along a break line coincident with the groove 18. In more detail, this step may be performed by placing the wafer 1 on a support 5 with the first major surface, covered by metallization layer 60, facing upwards before applying the wafer breaking force to the first major surface. This breaking step may advantageously be performed as schematically shown in FIG. 14 for example. This figure shows the wafer 1 being supported by support apparatus 5. The second major surface of the wafer 1, which is provided with devices 2 and which has grooves 18 scribed into it following step 34, faces downwardly, protected by the protective film 66. It can be seen that the wafer 1 is thereby retained within the frame 62, with the wafer 1 covered proximate its second major surface by the protective film 66, and covered at its first major surface by dicing tape 64. In this position, the wafer 1 is broken by applying the wafer breaking force downwardly, for example using a blade or chisel 6, at a location directly overlying a respective groove 18. Although the application of the wafer breaking force is sufficient to break the wafer 1, it is generally not sufficient to also break the metallization layer 60. After breaking the wafer 1 in this way, a break line 68 (see FIG. 15) will be formed extending the entire thickness of wafer 1, following the line of the coincident groove 18. This step may be repeated as required until the wafer 1 is broken along all scribelines.

In step 46, the frame 62, including the wafer 1, is inverted so that the second major surface faces upward, then, in step 48, a metallization breaking force is applied to the second major surface, to break the metallization layer 60, as schematically shown in FIG. 15. Conveniently, step 48 may be performed using the same apparatus as step 44. The blade or chisel 6 is aligned with a break line 68, causing the metallization layer 60 to break along a line directly adjacent that break line 68. This step is repeated to successively break regions of the metallization layer 60 adjacent each break line 68.

In step 50, the protective film 66 applied in step 42 is removed, which may be achieved simply, for example by pulling it off the wafer 1.

The process may now conclude at step 52. The wafer 1 may be removed from the frame 62 and dicing tape 64 and further used or processed as required.

The above-described embodiments are exemplary only, and other possibilities and alternatives within the scope of the invention will be apparent to those skilled in the art.

### Reference numerals used:

1 - Wafer
2 - Devices
3 - Scribelines
4 - Flexible sheet
5 - Support assembly
6 - Chisel
10 - Chuck
11 - Laser source
12 - Laser beam
13, 14 - Mirrors
15 - Beam shaper
16 - Sub-beams
17 - Spots
18 - Groove
19 - Upper surface
20 - Modified groove
21 - Spots
22 - Trough
23 - Irradiation pattern
d1 - Depth of groove
w1- Width of groove
d2 - Depth of modification region
w2 - Width of modification region
30 to 52 - Flowchart steps
60 - Metallization layer
62 - Frame
64 - Dicing tape
66 - Protective film
68 - Break line
70 - Ti layer
72 - Ni / NiV layer
74 - Au / Ag layer

## Claims

1. A method for breaking a substantially planar workpiece having first and second major surfaces, with a metallization layer on the first major surface, comprising the steps of:
i) forming a groove in the workpiece extending parallel to the plane, the groove being open at an upper surface of the workpiece, and then subsequently
ii) applying a workpiece breaking force to the first major surface of the workpiece to crack the workpiece along a break line coincident with the groove, then
iii) applying a metallization breaking force to the second major surface of the workpiece to break the metallization layer along the break line.

2. The method of claim 1, wherein step i) comprises irradiating the second major surface of the workpiece with incident laser light while moving the workpiece relative to the incident laser light in a translation direction, to form the groove.

3. The method of claim 1, wherein step i) comprises:
a) irradiating the workpiece with a first irradiation pattern of incident laser light while moving the workpiece relative to the incident laser light in a translation direction, to form a groove in the workpiece extending parallel to the plane, the groove being open at an upper surface of the workpiece and having a first sectional shape with a first depth d1, and then subsequently
b) irradiating the workpiece with a second irradiation pattern of incident laser light, while moving the workpiece relative to the incident laser light in a direction parallel to the translation direction, to modify an upper portion of the groove, the upper portion having a depth d2, where d2<d1, to produce a modified groove having a second sectional shape different to the first sectional shape.

4. The method of claim 1, wherein step i) is performed by using a laser source to generate a laser beam directed along an optical path to the workpiece, with a beam shaper positioned in the optical path to create an irradiation pattern at the workpiece.

5. The method of claim 1, wherein the workpiece has a thickness in the range 100 to 350 µm and the groove has a depth in the range 5 to 60 µm, optionally the workpiece has a thickness in the range 100 to 200 µm and the groove has a depth in the range 5 to 15 µm, optionally the workpiece has a thickness in the range 200 to 350 µm and the groove has a depth in the range 40 to 60 µm.

6. The method of claim 2, wherein the incident laser light has a wavelength in the range from 300 to 380 nm, optionally in the range 330 to 350 nm.

7. The method of claim 2, wherein the incident laser light comprises a pulsed beam with a frequency in the range 10 to 100 kHz and a pulse duration in the range 10 to 250 ns.

8. The method of claim 2, wherein the incident laser light comprises a pulsed beam with a frequency in the range 100 to 2000 kHz and a pulse duration in the range 0.1 to 10 ps.

9. The method of claim 2, wherein the incident laser light has a power in the range 0.1 to 10 W.

10. The method of claim 1, wherein step ii) comprises applying a protective film over the second major surface before applying the workpiece breaking force to the first major surface.

11. The method of claim 1, wherein step ii) comprises placing the workpiece on a support with the first major surface facing upwards before applying the workpiece breaking force to the first major surface, and wherein step iii) comprises inverting the workpiece so that the second major surface faces upward, and applying the metallization breaking force to the second major surface.

12. The method of claim 1, wherein the workpiece comprises silicon carbide.

13. A method for scribing a substantially planar workpiece, comprising the steps of:
i) irradiating the workpiece with a first irradiation pattern of incident laser light while moving the workpiece relative to the incident laser light in a translation direction, to form a groove in the workpiece extending parallel to the plane, the groove being open at an upper surface of the workpiece and having a first sectional shape with a first depth d1, and then subsequently
ii) irradiating the workpiece with a second irradiation pattern of incident laser light, while moving the workpiece relative to the incident laser light in a direction parallel to the translation direction, to modify an upper portion of the groove, the upper portion having a depth d2, where d2<d1, to produce a modified groove having a second sectional shape different to the first sectional shape.

14. The method of claim 13, wherein each of steps i) and ii) is performed by using a laser source to generate a laser beam directed along an optical path to the workpiece, with a beam shaper positioned in the optical path to create the respective first or second irradiation pattern at the workpiece.

15. The method of claim 13, wherein step ii) comprises removing heat-affected material of the workpiece proximate the upper portion of the groove.

16. The method of claim 14, wherein the first irradiation pattern comprises a linear array of spatially-separated laser sub-beams split from the respective laser beam.

17. The method of claim 14, wherein the second irradiation pattern comprises a plurality of sub-beams arranged in a V-shaped pattern such that the width of the pattern, orthogonal to the translation direction, increases in the translation direction.

18. The method of claim 13, wherein the second irradiation pattern comprises a plurality of pairs of sub-beams spaced parallel to the translation direction, each pair comprising first and second sub-beams spaced in the horizontal direction orthogonal to the translation direction, with the spacing between the first and second sub-beams of each pair increasing in the translation direction.

19. The method of claim 13, wherein the substantially planar workpiece comprises silicon carbide.

20. A method for dicing a substantially planar workpiece, comprising scribing the workpiece using the method of claim 13 to create at least one modified groove in the workpiece, followed by the step:
iii) mechanically breaking the scribed workpiece along the at least one modified groove.
